# FASCICULE DE BREVET EUROPEEN

(11) **EP 3 877 791 B1**
(45) Date de publication et mention de la délivrance du brevet: **14.02.2024**
(21) Numéro de dépôt: 19817402.1
(22) Date de dépôt: 07.11.2019
(51) Int. Cl.: G02B 5/28, G01J 3/26, G02B 26/00, H01L 27/146

(54) **PROCEDE DE FABRICATION D'UN FILTRE MULTI-SPECTRAL ET FILTRE MULTI-SPECTRAL AINSI FABRIQUE**
VERFAHREN ZUR HERSTELLUNG EINES MULTISPEKTRALFILTERS UND SO HERGESTELLTER MULTISPEKTRALFILTER
METHOD FOR MANUFACTURING A MULTI-SPECTRAL FILTER AND MULTI-SPECTRAL FILTER THUS MANUFACTURED

(30) Priorité: 08.11.2018 FR 1860296
(43) Date de publication de la demande: 15.09.2021
(73) Titulaire: Safran Reosc, 91280 Saint-Pierre-du-Perray (FR)
(72) Inventeur: PORTIER, Benjamin, 91280 SAINT-PIERRE-DU-PERRAY (FR); LEPLAN, Hervé, 91280 SAINT-PIERRE-DU-PERRAY (FR); LHUILLIER, Rémi, 91280 SAINT-PIERRE-DU-PERRAY (FR)
(74) Mandataire: Ipsilon
(86) Numéro de dépôt international: PCT/FR2019/052650
(87) Numéro de publication internationale: WO 2020/094996

(56) Documents cités:
- CN-A- 102 054 772
- KR-A- 20040 036 967
- US-A1- 2014 327 099
- US-A1- 2017 294 478
- CONVEY DIANA ET AL: "Fabrication of a monolithically integrated multiple wavelength Fabry-Perot filter array using transparent etch stop layers for accurate wavelength determination", PROCEEDINGS SPIE 7513, 2009 INTERNATIONAL CONFERENCE ON OPTICAL INSTRUMENTS AND TECHNOLOGY, SPIE, 1000 20TH ST. BELLINGHAM WA 98225-6705 USA , vol. 6378 18 octobre 2006 (2006-10-18), page 637815, XP009514105, ISSN: 0277-786X, DOI: 10.1117/12.684937 ISBN: 978-1-5106-2781-9 Extrait de l'Internet: URL:http://proceedings.spiedigitallibrary. org/proceeding.aspx?doi=10.1117/12.684937 [extrait le 2006-10-17]

## Description

La présente invention concerne un procédé de fabrication d'un filtre multi-spectral comprenant une pluralité de filtres à cavités et un filtre obtenu par un tel procédé.

Des filtres à cavités sont aussi appelés des filtres Fabry-Pérot. Un filtre Fabry-Pérot consiste en une cavité optique formée par un milieu interstitiel en matériau transparent entreposé entre deux réflecteurs (ou miroirs). Les réflecteurs peuvent être des empilements de matériaux diélectriques, des couches métalliques, etc. Ce type de filtre transmet une bande spectrale très étroite (à la longueur d'onde de résonance) et rejette les autres longueurs d'onde. La longueur d'onde de résonance est déterminée principalement par l'épaisseur de la cavité et son indice de réfraction, et elle dépend, dans une moindre mesure de la nature des réflecteurs.

Lorsqu'une onde lumineuse se propage dans cette structure, elle effectue plusieurs allers-retours dans le milieu interstitiel du fait de sa réflexion aux réflecteurs. Lorsque la longueur d'onde est celle de résonance, la phase accumulée après chaque aller-retour est égale à un nombre entier de fois 2π, ce qui se traduit par une transmission plus importante de l'onde vers le milieu extérieur par rapport aux autres longueurs d'onde de la bande spectrale utilisée qui sont rejetées par le filtre.

Une pluralité d'éléments filtrants ou filtres Fabry-Pérot peut être agencée sous la forme d'une matrice. Ces filtres peuvent avoir des longueurs d'onde de transmission différentes de l'un à l'autre de sorte que la matrice forme un filtre multi-spectral. De telles matrices sont composées d'empilements multicouches, comprenant des empilements pour des cavités optiques et des empilements pour former des réflecteurs de part et d'autre des cavités. Les épaisseurs optiques des cavités varient d'un élément filtrant à l'autre sur la matrice afin de disposer de pics de transmission dans la gamme spectrale souhaitée. Les empilements des réflecteurs sont, quant à eux, identiques pour tous les éléments filtrants.

Des matrices de filtres Fabry-Pérot sont couramment utilisées pour des applications d'imagerie multi-spectrale ou de spectroscopie. Les plages de longueurs d'onde utilisées se situent le plus souvent dans le spectre visible ou infrarouge.

Les procédés de fabrication de telles matrices de filtres consistent, d'une part, en des étapes de dépôt de couches pour réaliser les éléments commun à tous les composants, comme les miroirs ou des couches apodisantes, et, d'autre part, en des étapes de structuration des cavités permettant d'ajuster la longueur d'onde de résonance de chaque filtre.

Pour structurer les cavités et obtenir les différentes épaisseurs optiques souhaitées, on peut distinguer deux catégories de méthodes : des méthodes additives et des méthodes soustractives.

Les méthodes additives consistent en une étape commune de dépôt du matériau ou des matériaux de la cavité pour réaliser la cavité la moins épaisse de la matrice, et des étapes de dépôt supplémentaires pour augmenter de manière sélective les épaisseurs de certaines cavités des filtres. Les méthodes additives reposent sur des techniques de dépôt de couches minces sous vide. Combinées à des moyens de contrôle de croissance des couches, elles permettent d'atteindre des précisions sur les épaisseurs de couche de l'ordre du nanomètre. Les méthodes soustractives, quant à elles, consistent en une étape commune de dépôt du matériau ou des matériaux de la cavité pour réaliser la cavité la plus épaisse, et des étapes supplémentaires servent à diminuer de manière sélective l'épaisseur de certaines cavités des filtres résonnant à des longueurs d'onde plus basses. Ces étapes supplémentaires peuvent inclure, par exemple, des techniques d'ablation laser, de gravure plasma ou de gravure humide.

Cependant, les étapes de gravure ne permettent pas d'atteindre des précisions de quelques nanomètres sur les épaisseurs des cavités, nécessaires à l'obtention des réponses spectrales souhaitées. Ceci est dû à une variation des vitesses de gravure entre les différentes étapes de structuration, compromettant ainsi la répétabilité de l'opération. De plus, le fond de gravure n'est pas parfaitement plat - il peut remonter légèrement ou bien former des rigoles à proximité des bords de la zone de gravure. Il n'est donc pas possible d'obtenir une épaisseur de couche constante sur la zone concernée.

La précision sur l'épaisseur optique de la ou des cavités d'une matrice de filtres revêt une grande importance dans la mesure où l'épaisseur d'une cavité définit directement la position spectrale de la bande passante du filtre concerné. Ainsi, une variation de quelques nanomètres sur l'épaisseur de cavité a pour conséquence de décaler spectralement d'à peu près autant la bande passante du filtre. Lorsque la précision de l'épaisseur n'est pas contrôlée le risque est donc de ne plus détecter le rayonnement dans la bande passante souhaitée.

L'invention vise à remédier à au moins un des inconvénients précités en proposant un procédé de fabrication d'un filtre multi-spectral par une méthode soustractive.

Selon un premier aspect, l'invention a ainsi pour objet un procédé selon la revendication 1.

Le procédé ci-dessus présente de nombreux avantages.

Ce procédé permet de réaliser un filtre multi-spectral comprenant une matrice d'éléments filtrants par une méthode soustractive combinant une étape de dépôt des couches et des étapes de gravure sélective. Les étapes de gravure sélective permettent d'obtenir des éléments filtrants ayant des épaisseurs de cavité spécifiques à chaque élément filtrant. Les éléments filtrants sont par exemple disposés les uns à côté des autres sur le substrat.

Les éléments filtrants ainsi réalisés comprennent chacun des cavités Fabry-Pérot composées d'empilements multicouches d'au moins deux matériaux. Les étapes de gravure sélective utilisent des recettes de gravures spécifiques à ces matériaux.

Selon une possibilité, lorsqu'une couche de cavité est gravée, la gravure s'arrête lorsque la couche d'arrêt est atteinte et la couche d'arrêt reste intacte, et vice versa. Les épaisseurs optiques des différents éléments filtrants sont par exemple obtenues en alternant la gravure sélective des couches de cavité avec la gravure sélective des couches d'arrêt. Les couches sont ainsi gravées en alternance, l'une après l'autre. Grâce à la sélectivité lors des gravures et la présence de couches d'arrêt, la précision sur les épaisseurs gravées peut être inférieure au nanomètre. La précision sur les épaisseurs optiques des couches et ainsi des cavités est donc celle de la méthode de dépôt utilisée, comme pour les méthodes additives. Suivant cette possibilité, la vitesse de gravure d'un matériau B (ex : matériau des couches d'arrêt) est plus rapide (par exemple d'un facteur 10) que celle d'un matériau A (matériau des couches de cavité) pour la recette de gravure pour le matériau B et la vitesse de gravure du matériau A est plus rapide (par exemple d'un facteur 20) que celle du matériau B pour la recette de gravure pour le matériau A.

Selon une autre possibilité alternative, une même recette de gravure sélective adaptée normalement pour un matériau A (il s'agit ici du matériau des couches de cavité) peut être utilisée pour graver plusieurs couches de cavité d'un matériau A et plusieurs couches d'arrêt d'un matériau B avant de graver la dernière couche d'arrêt de matériau B avec une recette spécifique à ce dernier matériau. Ceci est notamment basé sur le fait que la vitesse de gravure du matériau B est plus rapide (par exemple d'un facteur 20) que celle du matériau A pour la recette de gravure pour le matériau B. Cette possibilité permet d'obtenir une bonne précision sur les dernières couches non gravées, c'est-à-dire les couches de cavité.

Plus de deux matériaux optiquement transparents peuvent être utilisés pour fabriquer la structure d'éléments filtrants à cavité et par exemple, l'une des couches (cavité ou arrêt) peut être réalisée en deux matériaux différents. Dans ce cas il est possible d'utiliser la même recette de gravure pour graver la couche bi-matériaux.

La méthode soustractive selon l'invention nécessite au moins autant d'étapes qu'une méthode additive équivalente. Il est ainsi possible d'obtenir 2^{N} épaisseurs optiques de cavité différentes en N étapes de gravure sélective. En revanche, la durée de chaque étape de gravure est de l'ordre de quelques dizaines de minutes, contre quelques heures pour chaque étape de dépôt avec une méthode additive, en raison notamment des durées de pompage de la machine de dépôt de couche. Il est donc possible de réaliser un gain de temps important avec la méthode soustractive selon l'invention.

Les matériaux utilisés pour l'ensemble des couches (couches de cavité et couches d'arrêt) constituant le filtre multi-spectral doivent être optiquement transparents et ne doivent pas absorber le rayonnement électromagnétique dans la bande spectrale d'intérêt des éléments filtrants afin de ne pas dégrader leurs performances optiques. Cette condition s'applique notamment aux matériaux pour les couches d'arrêt qui ne doivent pas compromettre les caractéristiques de transmission des matériaux utilisés pour les couches de cavité. Les recettes de gravure pour graver chacun de ces matériaux doivent être adaptées en conséquence.

Selon un exemple de réalisation possible, les couches de cavité sont en Germanium et les couches d'arrêt sont en sulfure de zinc, en oxyde d'yttrium(III) ou en fluorure d'yttrium(III). Ces matériaux sont tous transparents dans au moins une partie du spectre infra-rouge.

Selon un autre exemple de réalisation possible, les couches de cavité sont en sulfure de zinc, en oxyde d'yttrium(III) ou en fluorure d'yttrium(III) et les couches d'arrêt sont en Germanium.

Selon encore un autre exemple de réalisation, les couches de cavité sont en oxyde d'yttrium(III) et les couches d'arrêt sont en silice ou inversement. Ces matériaux sont tous transparents dans le spectre visible.

Préférentiellement, le substrat est constitué par la surface sensible d'un photo-détecteur infra-rouge ou visible. Les étapes de gravure sélective mettent en oeuvre des techniques de gravure (par exemple par voie chimique ou ionique) qui sont compatibles avec la réalisation de matrices de filtres Fabry-Perot sur la surface de tels détecteurs dans la mesure où ces techniques ne dégradent pas les propriétés électro-optiques de ces détecteurs, notamment en termes de sensibilité, de niveau de bruit...

Le substrat peut également être un substrat en matériau diélectrique transparent dans la bande spectrale d'intérêt.

Les couches de cavité et les couches d'arrêt sont disposées en alternance de manière à former des strates successives les unes au-dessus des autres. Les couches d'arrêt sont positionnées aux épaisseurs optiques souhaitées pour les différents éléments filtrants.

Selon un premier mode de réalisation possible, la cavité de chaque élément filtrant est majoritairement (par exemple d'un facteur 10) composée du matériau des couches de cavité. L'épaisseur des couches d'arrêt est petite (par exemple d'un facteur 0,1) comparée à l'épaisseur des couches de cavité. L'épaisseur optique d'une cavité correspond essentiellement à l'épaisseur d'une ou de N couches de cavité et de zéro ou N-1 couches d'arrêt. Pour chaque épaisseur optique souhaitée d'une cavité, on grave successivement une couche de cavité puis une couche d'arrêt. Pour obtenir une grande précision sur les épaisseurs optiques des éléments filtrants, la recette de gravure permettant d'éliminer les couches d'arrêt est de préférence sélective vis-à-vis du matériau des couches de cavité (par exemple avec une sélectivité d'un facteur supérieur à 2). Selon ce mode de réalisation, par exemple 2^{N} éléments filtrants peuvent être réalisés en 2N étapes de gravure sélective.

Selon un deuxième mode de réalisation possible, la cavité de chaque élément filtrant est également composée d'une alternance de couches de cavité et de couches d'arrêt. L'épaisseur optique d'une cavité peut correspondre à l'épaisseur d'une couche de cavité ou à la somme des épaisseurs d'une ou plusieurs couches de cavité et d'une ou plusieurs couches d'arrêt. Les différentes épaisseurs optiques souhaitées des éléments filtrants sont obtenues en éliminant une couche de cavité ou une couche d'arrêt à la fois, au lieu d'éliminer deux couches successives comme dans le premier mode ci-dessus. Les recettes de gravure permettant de graver respectivement le matériau des couches de cavité et le matériau des couches d'arrêt sont de préférence sélectives vis-à-vis de l'autre matériau (par exemple avec une sélectivité d'un facteur supérieur à 2). Selon ce mode de réalisation, par exemple 2^{N} éléments filtrants peuvent être réalisés en N étapes de gravure sélective.

Selon un mode de réalisation possible, le procédé comprend en outre le dépôt d'un second réflecteur commun sur les cavités pour la pluralité d'éléments filtrants suite aux gravures sélectives.

De manière avantageuse, le procédé peut comprendre en outre :
- le dépôt, sur le second réflecteur, d'un empilement de cavité supplémentaire identique au premier empilement de cavité, et
- la répétition des étapes de gravure sélective pour l'empilement supplémentaire, de façon à ce que chaque élément filtrant comprenne le même nombre de couches de cavité dans le premier empilement et l'empilement supplémentaire et le même nombre de couches d'arrêt dans les deux empilements.

Selon ce mode de réalisation, des éléments filtrants ayant deux cavités identiques superposées peuvent être réalisés. Les deux cavités de chaque élément filtrant se trouvent ainsi sur le trajet optique d'une onde, l'une après l'autre, ce qui permet de former un élément filtrant amélioré ayant une réjection améliorée par rapport à une seule cavité. On peut ainsi obtenir un élément filtrant avec une sélectivité spectrale améliorée (par exemple d'un facteur 4) par rapport à l'art antérieur.

Selon un autre mode de réalisation possible qui dépend du mode précédent, le procédé comprend en outre le dépôt d'un troisième réflecteur commun pour la pluralité d'éléments filtrants sur les cavités de l'empilement de cavité supplémentaire.

De manière avantageuse, le procédé selon le premier aspect de l'invention peut être étendu au dépôt et aux gravures d'autres empilements de cavité supplémentaires, afin de réaliser un filtre ayant des éléments filtrants avec trois cavités ou plus.

La précision de gravure, lorsque les éléments filtrants comportent deux cavités ou plus, est d'autant plus importante car la résonance de transmission d'un élément filtrant diminue rapidement si les cavités de cet élément ne résonnent pas à la même longueur d'onde.

Selon des modes de réalisation possibles de l'invention, les réflecteurs comprennent l'un, au moins, parmi un empilement de couches diélectriques, un miroir métallique, et un empilement de cristaux photoniques. Un réflecteur peut aussi être constitué par l'interface entre la cavité et le milieu extérieur, c'est-à-dire l'air ou le vide.

Selon un autre mode de réalisation possible, le procédé comprend en outre le dépôt d'une couche de protection préalablement à chaque gravure sélective des couches de cavité sur les zones non gravées des couches de cavité.

Les couches de protection peuvent, par exemple, être déposées par photolithographie.

Le dépôt des réflecteurs et des empilements de cavité peut être réalisé par une méthode de dépôt sous vide, par exemple par évaporation thermique, par dépôt physique en phase vapeur ou par dépôt chimique en phase vapeur assisté par plasma.

Le procédé selon l'invention peut comprendre en outre le dépôt, sur le substrat, d'une couche de passivation, d'une couche anti-diffusion, d'une couche de filtre large-bande et/ou d'une couche d'adhésion avant le dépôt du premier réflecteur. Le procédé peut également comprendre le dépôt d'une couche d'encapsulation en dernière étape afin de protéger le filtre obtenu contre d'éventuels endommagements mécaniques.

Dans le procédé selon la présente invention, le nombre N est égal ou supérieur à 2.

De manière générale, les couches du ou des empilements de couches précités (lorsqu'il y plusieurs empilements) sont déposées en une seule opération de dépôt. Il est ainsi possible de suivre l'évolution de la réponse optique du ou des éléments filtrants au cours du dépôt avec un système de suivi, par exemple optique, qui permet de contrôler la croissance et l'épaisseur des couches.

Selon un deuxième aspect, l'invention a pour objet un filtre multi-spectral fabriqué selon le procédé du premier aspect de l'invention. Le filtre comporte les avantages mentionnés ci-dessus en relation avec le procédé.

D'autres caractéristiques et avantages de l'invention apparaîtront à la lecture de la description suivante, donnée uniquement à titre d'exemple non limitatif, et faite en référence aux dessins annexés, sur lesquels :
- la figure 1 représente un schéma d'une coupe d'un filtre multi-spectral selon un mode de réalisation de l'invention,
- la figure 2 illustre les étapes d'un procédé de fabrication d'un filtre multi-spectral selon un mode de réalisation,
- la figure 3 illustre les étapes d'un procédé de fabrication d'un filtre multi-spectral selon un autre mode de réalisation, et
- les figures 4A et 4B montrent des spectres de transmission pour un filtre multi-spectral selon l'invention ayant cinq éléments filtrants, selon des modes de réalisation différents.

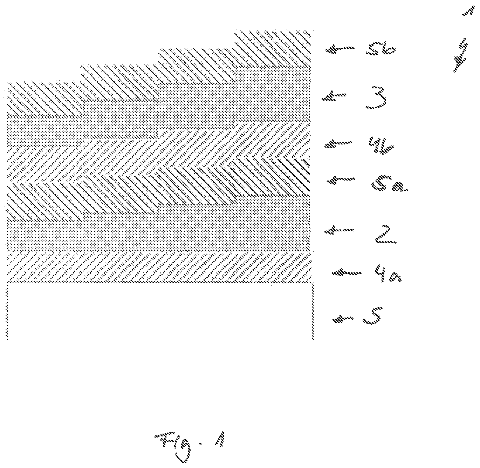

Un exemple d'un filtre multi-spectral selon l'invention est présenté sur la figure 1. Selon cet exemple, le filtre 1 comporte quatre éléments filtrants à cavité. Chaque élément filtrant comporte ici deux cavités 2, 3 superposées suivant la hauteur ou épaisseur du filtre (axe vertical sur la figure 1). Les deux cavités de chaque élément filtrant ont ici la même épaisseur. Les deux cavités 2, 3 sont délimitées de part et d'autre par un réflecteur inférieur 4a, 4b et un réflecteur supérieur 5a, 5b. Le filtre 1 est réalisé sur une face supérieure d'un substrat S. Dans cet exemple les réflecteurs 4a, 4b, 5a, 5b sont ici identiques pour tous les éléments filtrants. Les réflecteurs inférieurs 4a, 4b sont par exemple identiques entre eux, et les réflecteurs supérieurs 5a, 5b sont par exemple identiques entre eux également. Ainsi, pour chaque élément filtrant, les deux cavités 2, 3 ont sensiblement les mêmes caractéristiques. Selon des variantes de réalisation non représentées, les réflecteurs 4a, 4b, 5a, 5b ne sont pas identiques pour tous les éléments filtrants.

De préférence, les cavités ainsi que les réflecteurs sont notamment formés par une ou plusieurs couches diélectriques empilées. Les réflecteurs peuvent être, par exemple, des miroirs de Bragg comprenant des empilements de couches de deux matériaux en alternance. Les matériaux utilisés pour les cavités et les réflecteurs doivent avoir des coefficients d'absorption faibles dans la bande spectrale visée.

Les réflecteurs peuvent alternativement être réalisés par des couches métalliques, des empilements de cristaux photoniques, des réseaux, ou par l'interface de la couche supérieure avec le milieu extérieur.

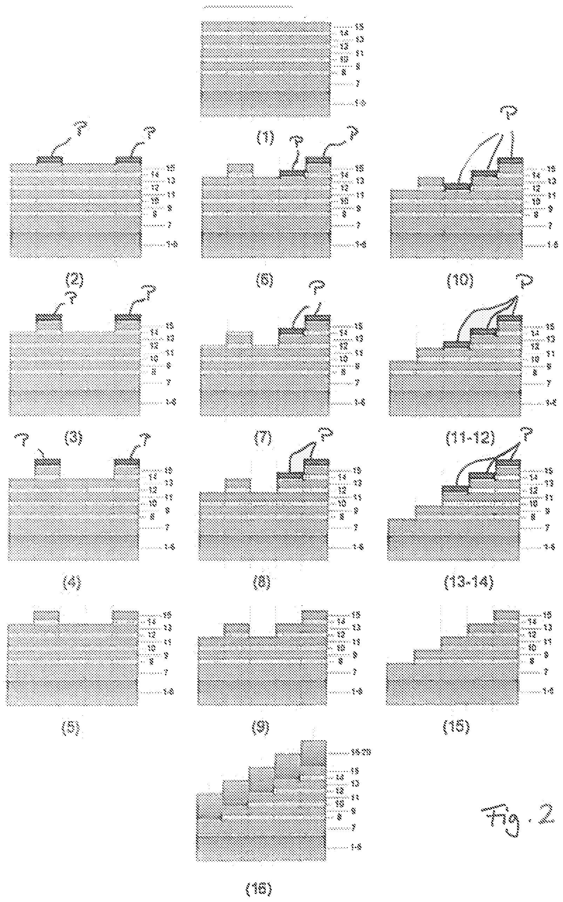

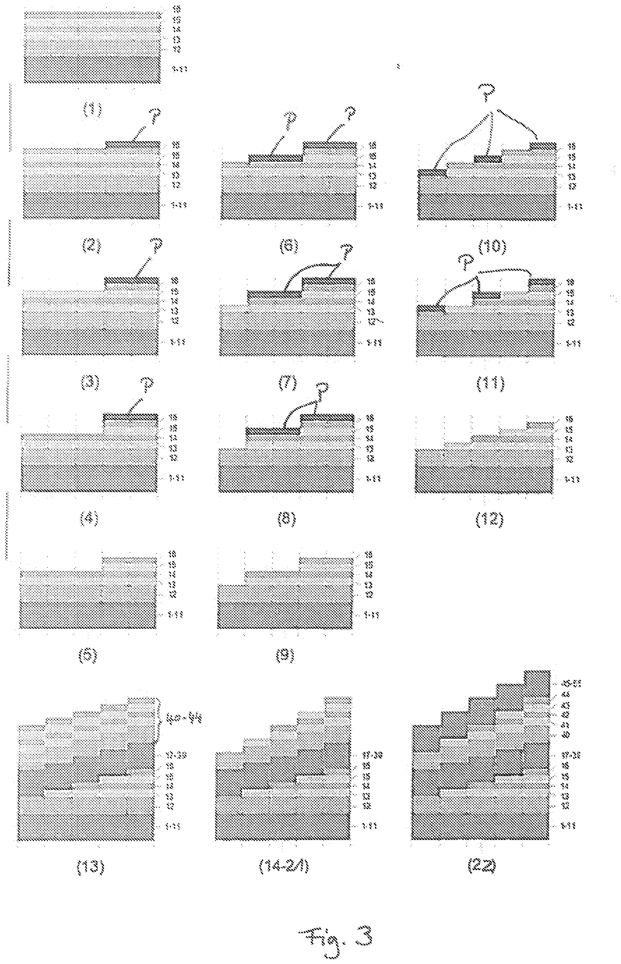

Des modes de réalisation possibles du procédé pour la fabrication d'un filtre multi-spectral comprenant une pluralité d'éléments filtrants sont illustrés en référence aux figures 2 et 3.

Le filtre multi-spectral est par exemple une matrice d'éléments filtrants à cavité où chaque élément filtrant est adapté pour transmettre une bande spectrale de rayonnement électromagnétique parmi une pluralité de bandes spectrales. Une matrice peut comporter un ou plusieurs éléments filtrants pour transmettre une bande spectrale parmi la pluralité de bandes. Chaque bande spectrale est caractérisée par un spectre de transmission présentant un pic de résonance bien marqué (avec par exemple un facteur d'au moins 10 entre la bande transmise et la bande non transmise). Les éléments filtrants sont par exemple répartis à la surface d'un substrat suivant différentes positions dans un plan x, y parallèle à la surface du substrat. Les éléments filtrants sont représentés sur les dessins décrits ci-après agencés suivant une ligne (axe x ou y du plan non illustré sur les dessins) mais d'autres éléments filtrants peuvent également être agencés suivant une ligne perpendiculaire (autre axe du plan) de manière à former un agencement matriciel sur le substrat. L'agencement des éléments filtrants peut aussi être réalisé en bandes linéaires ou selon d'autres motifs et, ceci, avec des dimensions constantes ou variables selon la position à la surface du substrat.

Le procédé selon un premier mode de réalisation est illustré à la figure 2, qui représente un exemple de procédé pour fabriquer un filtre multi-spectral comprenant ici cinq éléments filtrants. Chaque élément filtrant comprend par exemple une cavité. Le procédé qui va être décrit s'applique de la même manière pour un nombre d'éléments filtrants différent et/ou pour un nombre de cavités différent par élément filtrant. De manière générale, le procédé comprend les étapes suivantes.

Étape (1) de la figure 2 :
Un premier réflecteur commun pour les cinq éléments filtrants est déposé sur un substrat (non représenté). Le premier réflecteur commun comprend un empilement de couches 1 à 6. Sur le premier réflecteur est déposé un premier empilement de cavité comprenant au moins N couches de cavité et N-1 couches d'arrêt déposées en alternance, la couche supérieure étant une couche de cavité. Dans l'exemple illustré, le premier empilement de cavité est composé des couches 7 à 15, la couche 7 étant une couche de cavité, la couche 8 une couche d'arrêt, et ainsi de suite jusqu'à la couche supérieure 15 qui est une couche de cavité. Les couches de cavité sont réalisées en un matériau différent de celui des couches d'arrêt. Les deux matériaux sont optiquement transparents.

De manière avantageuse, les couches 1 à 15 peuvent être déposées en une seule opération de dépôt dans le dispositif de dépôt (ex : bâti de dépôt sous vide).

Le dépôt des couches peut être réalisé par une méthode de dépôt sous vide, par exemple par évaporation thermique, par dépôt physique en phase vapeur ou par dépôt chimique en phase vapeur assisté par plasma. Pour contrôler la croissance et l'épaisseur des couches, des méthodes connues optiques ou piézoélectriques peuvent être utilisées pour permettre de suivre l'évolution de la réponse optique des éléments filtrants au cours du dépôt. Il est ainsi possible de déterminer à quel moment la croissance d'une couche doit être arrêtée pour passer à la suivante, ce qui permet d'obtenir une très bonne précision sur les épaisseurs déposées. Lorsqu'un système de suivi optique est par exemple utilisé pour suivre l'évolution de la réponse optique des éléments filtrants au cours du dépôt et que toutes les couches sont déposées en une seule opération de dépôt, la configuration du système de suivi optique reste la même (la part de l'erreur systématique induite par la configuration du système est la même pour toutes les sous-couches d'une cavité), ce qui permet d'obtenir une meilleure précision sur les épaisseurs déposées. En effet, dans l'art antérieur, lors des dépôts des sous-couches d'une cavité en plusieurs opérations, le système de suivi optique doit être reconfiguré à chaque opération, engendrant ainsi une erreur systématique différente.

Les étapes de gravure sélective d'un nombre M (avec M variant de 0 à N-1) de couches de cavité dans une pluralité de zones adjacentes correspondant chacune à un élément filtrant, et des couches d'arrêt situées entre les couches de cavité gravées, peuvent être réalisées comme suit. Ici, le nombre N des couches de cavité est égal à 5.

Étapes (2) à (14) de la figure 2 :
La couche supérieure de cavité 15 est gravée en utilisant la différence de vitesse de gravure des couches de cavité (étape (3)).

Pour protéger les zones qui ne doivent pas être gravées, une couche protectrice P est déposée préalablement sur ces zones (étape ((2)). La couche protectrice peut être une résine photosensible déposée sur l'ensemble des zones par photolithographie. La résine est ensuite irradiée en utilisant un masque avec des zones opaques et des zones transparentes disposées de manière appropriée en fonction des zones de couches empilées adjacentes à graver et celles à protéger. Pendant le développement, les zones irradiées ou non, selon le type de la résine, sont éliminées, la résine restante couvrant ainsi les zones qui ne doivent pas être gravées.

La couche protectrice peut aussi être une couche en matériau diélectrique ou métallique.

La gravure peut être faite par gravure plasma ou ionique ou trempe en solution chimique. L'épaisseur de la couche protectrice P est telle que la couche protectrice ne doit pas être totalement gravée avant que la couche supérieure 15 de cavité n'ait été complètement éliminée.

Ensuite, la couche d'arrêt 14 située en dessous de la couche supérieure 15 gravée est gravée en utilisant la différence de vitesse de gravure des couches inférieures par rapport au matériau des couches d'arrêt (étape (4)).

La couche protectrice P est ensuite éliminée (étape (5)), par exemple à l'aide d'un solvant ou par gravure plasma.

Selon une variante, la couche d'arrêt 14 peut être gravée après l'élimination de la couche de protection P.

Selon l'exemple de la figure 2, les étapes de gravure sélective décrites ci-dessus sont répétées une fois pour graver localement la couche de cavité 13 puis la couche d'arrêt 12 (étapes (6) à (9)), tout en protégeant localement par une couche protectrice P les zones qui ne sont pas à graver. La couche protectrice P est ensuite retirée comme expliqué ci-dessus (étape (9)). Les étapes de gravure sélective décrites ci-dessus sont répétées encore deux fois pour graver les couches 11 à 8 (étapes (10) à (14)) tout en protégeant localement par une couche protectrice P les zones qui ne sont pas à graver. Pendant ces dernières gravures, la couche protectrice P reste toutefois en place entre les gravures des couches 11, 10 et celles des couches 9, 8. De ce fait, la couche protectrice ne doit pas être totalement gravée avant que les couches 11 à 8 n'aient été complètement gravées. La couche protectrice P est retirée après la dernière gravure (étape (15)).

Selon une variante, la dernière couche d'arrêt 8 peut être gravée après l'élimination de la couche de protection P.

La précision avec laquelle les différentes couches peuvent être gravées et donc la précision des épaisseurs obtenues dépend de la sélectivité des recettes ou techniques de gravure pour les différents matériaux. Idéalement, le matériau des couches de cavité (matériau A) n'est pas gravé par la recette adaptée au matériau des couches d'arrêt (matériau B). Ainsi, une recette de gravure destinée à graver le matériau d'une couche donnée ne doit généralement pas graver le matériau de la couche inférieure. Ce cas de figure n'est cependant pas applicable à toutes les combinaisons de matériaux de couches. Il est toutefois possible de fixer une condition limite pour les vitesses de gravure du matériau A et du matériau B avec la recette pour le matériau B. Cette condition de sélectivité de gravure peut être définie de la façon suivante : v_{B}^{B}/v_{A}^{B} > 20, où v_{A}^{B} et v_{B}^{B} sont respectivement les vitesses de gravure du matériau A et du matériau B pour la recette pour le matériau B. Il est ainsi possible de graver des couches de cavité et des couches d'arrêt avec une recette adaptée pour le matériau A (plutôt que de changer de recette de gravure pour chaque nouvelle couche à graver) et de ne graver que la dernière couche d'arrêt devant être éliminée avec une recette pour le matériau B. La recette sélective pour le matériau B permet d'obtenir une bonne précision (par exemple gravure de la couche de cavité inférieure à 2nm pour un filtre à 4µm) sur la ou les dernières couches non gravées, à savoir les couches de cavité. Le nombre d'étapes de gravure distinctes est ainsi réduit.

Le procédé qui vient d'être décrit ci-dessus peut donc utiliser une recette pour le matériau A pour graver des couches de cavité et des couches d'arrêt (ex : gravure des couches 15 à 9) et une recette pour le matériau B pour graver la dernière couche d'arrêt 8. Tout procédé de fabrication de filtre multi-spectral s'appliquant notamment à un nombre d'éléments filtrants différent, avec une ou plusieurs cavités chacun, peut également utiliser n'importe lequel des aspects ci-dessus, notamment relatifs à la sélectivité de gravure et aux vitesses de gravure.

Étape (16) de la figure (2) :
Une fois les étapes de gravure sélective terminées, un second réflecteur commun pour tous les éléments filtrants est par exemple déposé sur la structure d'éléments filtrants ainsi obtenue. Dans l'exemple présenté, le réflecteur comprend les couches 16 à 20. Le dépôt est fait selon des techniques connues décrites ci-dessus.

Le filtre multi-spectral selon un mode de réalisation ainsi fabriqué comprend cinq éléments filtrants ayant chacun une cavité avec une à cinq couches de cavité. Le nombre M varie de 0 à 4, c'est-à-dire qu'entre 0 et 4 couches de cavité ont été gravées sur l'ensemble du filtre pour réaliser les différentes épaisseurs de cavité, la cavité la moins épaisse correspondant à une couche de cavité et la cavité la plus épaisse correspondant à cinq couches de cavité. Les épaisseurs des couches d'arrêt sont telles qu'elles ne contribuent pas ou peu aux épaisseurs optiques des cavités.

Le procédé selon un deuxième mode de réalisation est illustré à la figure 3, qui représente un exemple de procédé pour fabriquer un filtre multi-spectral comprenant ici cinq éléments filtrants, chaque élément filtrant comprend par exemple deux cavités identiques. Le procédé qui va être décrit s'applique de la même manière pour un nombre d'éléments filtrants différent et/ou pour un nombre de cavités différent par élément filtrant. De manière générale, le procédé comprend les étapes suivantes.

Étape (1) de la figure 3 :
Un premier réflecteur commun pour les cinq éléments filtrants est déposé sur un substrat (non représenté). Le premier réflecteur commun comprend un empilement de couches 1 à 11. Sur le premier réflecteur est déposé un premier empilement de cavité comprenant au moins N couches de cavité et N-1 couches d'arrêt déposées en alternance, la couche supérieure étant une couche de cavité. Dans l'exemple illustré, le premier empilement de cavité est composé des couches 12 à 16, la couche 12 étant une couche de cavité, la couche 13 une couche d'arrêt, et ainsi de suite jusqu'à la couche supérieure 16 qui est une couche de cavité. Les couches de cavité sont réalisées en un matériau différent de celui des couches d'arrêt. Les deux matériaux sont optiquement transparents.

De manière avantageuse, les couches 1 à 16 peuvent être déposées en une seule opération de dépôt.

Le dépôt des couches peut être réalisé par une méthode de dépôt connue, comme décrit plus haut pour le mode de réalisation de la figure 2. Comme pour le mode de la figure 2, la croissance et l'épaisseur des couches peuvent être contrôlées de manière identique ici.

Les étapes de gravure sélective d'un nombre M (avec M variant de 0 à N-1) de couches de cavité dans une pluralité de zones adjacentes correspondant chacune à un élément filtrant, et des couches d'arrêt situées entre les couches de cavité gravées, peuvent être réalisées comme suit. Ici, le nombre N des couches de cavité du premier empilement est égal à 3.

Étapes (2) à (12) de la figure 3 :
Pour protéger les zones qui ne doivent pas être gravées, une couche protectrice P est déposée préalablement sur ces zones (étape ((2)), comme décrit précédemment pour le mode de la figure 2.

La couche supérieure 16 est gravée en utilisant une recette ou technique de gravure sélective par rapport au matériau des couches de cavité (étape (3)). La gravure peut être faite par gravure plasma ou chimique.

Ensuite, la couche d'arrêt 15 située en dessous de la couche supérieure 16 gravée est gravée en utilisant une recette ou technique de gravure sélective par rapport au matériau des couches d'arrêt (étape (4)).

L'épaisseur de la couche protectrice P est telle que la couche protectrice ne doit pas être totalement gravée avant que les couches 15 et 16 n'aient été complètement éliminées.

Les étapes de gravure peuvent être répétées plusieurs fois, selon le nombre de couches qui doivent être éliminées dans les zones concernées.

La couche protectrice P est ensuite éliminée (étape (5)), par exemple à l'aide d'un solvant ou par gravure plasma.

Pour les gravures suivantes, pour protéger de nouvelles zones adjacentes qui ne doivent pas être gravées, une couche protectrice P est déposée sur ces zones (étape ((6)). Les étapes de gravure sélective des deux types de couches mentionnées ci-dessus sont répétées (étapes (7) et (8)), et la couche protectrice est ensuite éliminée (étape (9)).

Les étapes (6), (7) et (9) sont ensuite répétées pour d'autres zones, tout en protégeant les zones qui ne sont pas à graver avec une couche protectrice P avant de l'éliminer (étapes (10) à (12)).

Étapes (13) à (22) de la figure 3 :
Une fois les étapes de gravure sélective pour la première cavité terminées, un second réflecteur commun pour tous les éléments filtrants est déposé sur la structure d'éléments filtrants obtenue. Dans l'exemple présenté, le second réflecteur comprend les couches 17 à 39. Le dépôt est fait selon des techniques connues décrites ci-dessus. Sur le second réflecteur est déposé un empilement de cavité supplémentaire qui est ici identique au premier empilement de cavité. Sur la figure 3, l'empilement de cavité supplémentaire correspond aux couches 40 à 44 (étape 13). En pratique, les couches 17 à 44 sont par exemple avantageusement déposées en une seule opération de dépôt.

Les étapes (2) à (9) décrites ci-dessus sont ensuite répétées afin d'obtenir, dans chaque zone de la structure correspondant à un élément filtrant, deux cavités identiques (étapes (14) à (21)).

La précision avec laquelle les différentes couches peuvent être gravées et donc la précision des épaisseurs obtenues dépend de la sélectivité des recettes ou techniques de gravure pour les différents matériaux. Idéalement, le matériau des couches de cavité (matériau A) n'est pas gravé par la recette adaptée au matériau des couches d'arrêt (matériau B). Ce cas de figure n'est cependant pas applicable à toutes les combinaisons de matériaux de couches. Il est toutefois possible de fixer une condition limite pour les vitesses de gravure du matériau A et du matériau B avec la recette pour le matériau B. Cette condition de sélectivité de gravure peut être définie de la façon suivante : v_{B}^{B}/v_{A}^{B} > 10, où v_{A}^{B} et v_{B}^{B} sont respectivement les vitesses de gravure du matériau A et du matériau B pour la recette pour le matériau B, et v_{A}^{A}/v_{B}^{A} > 10, où v_{A}^{A} et v_{B}^{A} sont respectivement les vitesses de gravure du matériau A et du matériau B pour la recette pour le matériau A. Pour ce deuxième mode de réalisation les deux recettes de gravure utilisées (l'une pour le matériau A et l'autre pour le matériau B) sont sélectives afin d'obtenir une bonne précision sur les dernières couches non gravées, à savoir les couches de cavité et les couches d'arrêt. Tout procédé de fabrication de filtre multi-spectral s'appliquant notamment à un nombre d'éléments filtrants différent, avec une ou plusieurs cavités chacun, peut également utiliser n'importe lequel des aspects ci-dessus, notamment relatifs à la sélectivité de gravure et aux vitesses de gravure.

Une fois toutes les étapes de gravure sélective terminées, un troisième réflecteur commun pour tous les éléments filtrants est par exemple déposé sur la structure d'éléments filtrants obtenue (étape (22)). Dans l'exemple présenté, le troisième réflecteur comprend les couches 45 à 55. Le dépôt est fait selon des techniques connues décrites ci-dessus.

Le filtre multi-spectral selon un mode de réalisation ainsi fabriqué comprend cinq éléments filtrants ayant chacun deux cavités. Les cavités du premier élément filtrant ont chacune une couche de cavité, les cavités du deuxième élément filtrant ont chacune une couche de cavité et une couche d'arrêt, et ainsi de suite. Les cavités du cinquième élément filtrant ont chacune trois couches de cavité et deux couches d'arrêt. Le nombre M varie de 0 à 3, c'est-à-dire qu'entre 0 et 3 (0, 1, 2, 3) couches de cavité et entre 0 et 2 (0, 1,2) couches d'arrêt ont été gravées sur l'ensemble du filtre pour réaliser les différentes épaisseurs de cavité. La cavité la moins épaisse correspond à une couche de cavité et la cavité la plus épaisse correspond à trois couches de cavité et deux couches d'arrêt.

Pour les cavités et les réflecteurs, des matériaux transparents dans l'infra-rouge et le visible peuvent être utilisés. Par exemple, dans l'infra-rouge, le Germanium, le sulfure de zinc (ZnS), l'oxyde d'yttrium(III) (Y₂O₃), le séléniure de zinc ou le fluorure d'yttrium(III) peuvent être utilisés. Dans le visible, la silice ou l'oxyde d'yttrium(III) peuvent être utilisés. Les réflecteurs peuvent être réalisés avec la même alternance de matériaux que les cavités, avec des épaisseurs de couches différentes entre les cavités et les réflecteurs.

Dans les modes de réalisation qui viennent d'être décrits, le ratio des épaisseurs des couches d'arrêt et de cavité déposées en alternance est généralement compris entre 5% et 20%.

Selon d'autres modes de réalisation du procédé selon l'invention, plus de deux matériaux optiquement transparents peuvent être utilisés pour fabriquer un filtre multi-spectral comprenant une pluralité d'éléments filtrants à cavité qui sont adaptés chacun à transmettre une bande spectrale de rayonnement électromagnétique parmi une pluralité de bandes spectrales possibles. Par exemple, les couches de cavité peuvent être réalisées en un matériau A. Les couches d'arrêt peuvent être réalisées en deux matériaux différents B et C, avec une couche en matériau C et les autres en matériau B. Le matériau C peut être gravé également avec la recette pour graver le matériau B. Dans ce cas, la condition de sélectivité des recettes de gravure est : v_{C}^{B}/v_{A}^{B} > 10, où v_{C}^{B} est la vitesse de gravure du matériau C pour la recette pour le matériau B. De manière similaire, au moins une des couches de cavité en matériau A peut être remplacée par une couche en matériau D, le matériau D se gravant avec la recette pour le matériau A. Dans ce cas, la condition de sélectivité est la suivante : v_{D}^{A}/V_{C}^{A}> 5, où V_{D}^{A} est la vitesse de gravure du matériau D pour la recette pour le matériau A.

Plusieurs techniques/recettes de gravure sélective (chimiques, réactives, ioniques...), notamment avec des facteurs de sélectivité d'environ 1 à 20, peuvent être utilisées en relation avec les modes de réalisation décrits ci-dessus.

A titre d'exemples de gravures chimiques :
- des couches en sulfure de zinc peuvent être gravées avec les solutions suivantes : HCl, HNO3, NH4OH :H2O2 :H2O (1 :1 :50) ;
- des couches en germanium peuvent être gravées avec les solutions suivantes : solution de Kern (PO4 :H2O2 :C2H5OH), solution de Ellis (HF :H2O2 :H2O), solution de Billig (H2O+KOH+K3[Fe(CN)6]), solution de Holmes (H2O2+NaOH) ;
- des couches en fluorure d'yttrium(III) peuvent être gravées avec une solution de HF ;
- des couches en oxyde d'yttrium(III) peuvent être gravées avec les solutions suivantes : HF, HCl, H2SO4, NaOH.

A titre d'exemples de gravures réactives (« Réactive Ion Etching » ou « RIE » en terminologie anglo-saxonne) :
- des couches en sulfure de zinc peuvent être gravées avec : CH4/H2, Cl2/Ar, CH4/H2/Ar ;
- des couches en germanium peuvent être gravées avec : SiCl4 :Cl2 : He, Cl2 100%, CF4, C2F6.

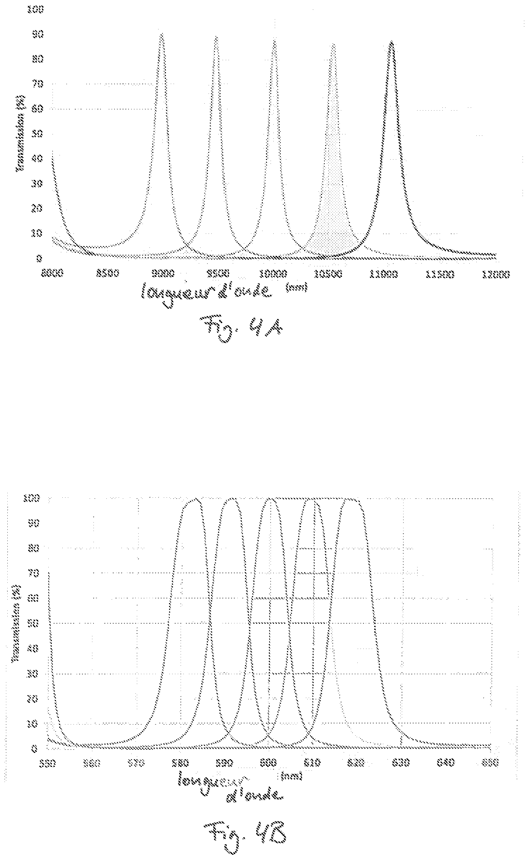

La figure 4A montre la transmission d'un filtre selon la présente invention fabriqué selon le premier mode de réalisation résonant à cinq longueurs d'onde distinctes dans la bande de 9 à 11 µm. Chaque élément filtrant comporte ici une cavité. Les couches de cavité sont en Germanium et les couches d'arrêt en ZnS. Les couches de cavité ont une épaisseur d'environ 120 nm (sauf la première qui est d'environ 950 nm), et les couches d'arrêt ont une épaisseur d'environ 20 nm. Les deux réflecteurs sont composés respectivement de trois et deux paires de couches d'épaisseur λ/4.

La figure 4B montre la transmission d'un filtre selon la présente invention fabriqué selon le deuxième mode de réalisation résonant à cinq longueurs d'onde distinctes dans la bande visible. Chaque élément filtrant comporte ici deux cavités. Les empilements de cavité ont chacun trois couches de cavité avec des épaisseurs respectives d'environ 140 nm, 12 nm et 12 nm. Les deux couches d'arrêt de chaque empilement de cavité ont des épaisseurs d'environ 12 nm chacune. Les couches de cavité sont en Y2O3 et les couches d'arrêt en Silice. Les trois réflecteurs sont composés respectivement de cinq, six et cinq paires de couches d'épaisseur λ/4.

Le filtre multi-spectral fabriqué selon le procédé de l'invention, quel que soit le mode de réalisation, constitue une matrice avec des pixels où chaque pixel correspond à un élément filtrant résonnant notamment à une longueur d'onde distincte (la matrice de pixels est généralement formée sur un substrat). Les pixels peuvent former des motifs quelconques qui peuvent être répétés sur la matrice. Chaque motif peut avoir une fonction filtrante spécifique. Un pixel peut avoir des dimensions comprises entre 5 et 30 µm. Les motifs peuvent avoir des dimensions comprises entre 5 µm et quelques cm. Pour une même matrice de pixels à motifs, les motifs peuvent être de dimensions différentes (au moins pour certains des motifs) et/ou de nombres différents (la matrice peut comporter différents nombres de motifs de types différents) et/ou de formes différentes (au moins pour certains des motifs, par exemple de forme carrée). Si la matrice comporte plusieurs tailles de motifs, la vitesse de gravure peut varier selon la taille du ou des motifs considérés.

Le filtre multi-spectral selon l'invention, quel que soit le mode de réalisation, peut être réalisé sur un substrat diélectrique. Le substrat peut être, par exemple, en Germanium, sulfure de zinc ou bromure de potassium, qui sont transparents dans l'infra-rouge. Le substrat peut être, par exemple, en silice ou en BK7 pour le visible. Le substrat peut également avoir un traitement optique sur son autre face, par exemple un traitement anti-reflet, ou un filtre passe-bande englobant les bandes de transmission des filtres élémentaires. Le filtre peut constituer ainsi une composante optique autonome utilisable dans des applications/systèmes d'imagerie multi-spectrale ou spectroscopiques.

Avantageusement, le filtre selon l'invention, quel que soit le mode de réalisation, peut être réalisé directement sur la surface sensible d'un composant électro-optique tel qu'un photo-détecteur captant dans l'infra-rouge ou le visible, par exemple d'un capteur matriciel au plan focal (FPA pour « *focal plane array* » en terminologie anglo-saxonne). On dispose ainsi d'un système d'imagerie multi-spectrale ou spectroscopique peu encombrant et qui est par ailleurs exempt des réflexions parasites qu'il peut y avoir entre un filtre et un détecteur.

## Revendications

1. Procédé pour la fabrication d'un filtre multi-spectral comprenant une pluralité d'éléments filtrants, chaque élément filtrant étant adapté pour transmettre une bande spectrale de rayonnement électromagnétique parmi une pluralité de bandes spectrales, **caractérisé en ce que** le procédé comprend les étapes suivantes :
- dépôt d'un premier réflecteur commun (1-6 ; 1-11) pour la pluralité d'éléments filtrants sur un substrat,
- dépôt, sur le premier réflecteur, d'un premier empilement de cavité (7-15 ; 12-16) comprenant au moins N couches de cavité et N-1 couches d'arrêt déposées en alternance, la couche supérieure étant une couche de cavité,
- gravure sélective d'un nombre M de couches de cavité dans une pluralité de zones correspondant chacune à un élément filtrant, où M varie de 0 à N-1 d'une zone à l'autre, et
- gravure sélective des couches d'arrêt situées entre les couches de cavité gravées,
de façon à ce que chaque élément filtrant comprenne N-M couches de cavité et N-M-1 couches d'arrêt non gravées formant une cavité,
les couches de cavité et les couches d'arrêt étant réalisées dans des matériaux différents et optiquement transparents,
les étapes de gravure sélective des couches de cavité et des couches d'arrêt étant effectuées :
- soit en gravant les couches de cavité et les couches d'arrêt en alternance, l'une après l'autre, avec une recette de gravure adaptée au matériau des couches de cavité et une recette de gravure adaptée au matériau des couches d'arrêt,
- soit en gravant les couches de cavité et les couches d'arrêt avec une recette de gravure adaptée au matériau des couches de cavité, à l'exception de la dernière couche d'arrêt qui est gravée avec une recette de gravure adaptée au matériau des couches d'arrêt.

2. Procédé selon la revendication 1, comprenant en outre :
- le dépôt d'un second réflecteur commun (16-20 ;17-39) sur les cavités pour la pluralité d'éléments filtrants suite aux gravures sélectives.

3. Procédé selon la revendication 2, comprenant en outre :
- le dépôt, sur le second réflecteur (17-39), d'un empilement de cavité supplémentaire (40-44) identique au premier empilement de cavité, et
- la répétition des étapes de gravure sélective pour l'empilement supplémentaire,
de façon à ce que chaque élément filtrant comprenne le même nombre de couches de cavité dans le premier empilement et l'empilement supplémentaire et le même nombre de couches d'arrêt dans les deux empilements.

4. Procédé selon la revendication 3, comprenant en outre :
- le dépôt d'un troisième réflecteur commun (45-55) pour la pluralité d'éléments filtrants.

5. Procédé selon l'une des revendications 1 à 4, dans lequel les réflecteurs comprennent l'un, au moins, parmi un empilement de couches diélectriques, un miroir métallique, et un empilement de cristaux photoniques.

6. Procédé selon l'une des revendications précédentes, dans lequel les couches de l'empilement sont déposées en une seule opération de dépôt.

7. Procédé selon l'une des revendications précédentes, comprenant en outre le dépôt d'une couche de protection préalablement à chaque gravure sélective des couches de cavité sur les zones non gravées des couches de cavité.

8. Procédé selon la revendication 7, dans lequel les couches de protection sont déposées par photolithographie.

9. Procédé selon l'une des revendications précédentes, dans lequel le substrat est constitué par la surface sensible d'un photo-détecteur infra-rouge.

10. Procédé selon l'une des revendications précédentes, dans lequel les couches de cavité sont en Germanium et les couches d'arrêt sont en sulfure de zinc, en oxyde d'yttrium(III) ou en fluorure d'yttrium(III) ou inversement.

11. Procédé selon l'une des revendications 1 à 9, dans lequel les couches de cavité sont en oxyde d'yttrium(III) et les couches d'arrêt sont en silice ou inversement.

12. Procédé selon l'une des revendications précédentes, dans lequel N est égal ou supérieur à 2.

13. Filtre multi-spectral fabriqué selon le procédé de l'une des revendications 1 à 12, le filtre comportant des couches de cavité et des couches d'arrêt, telles que le ratio des épaisseurs des couches d'arrêt et de cavité déposées en alternance est généralement compris entre 5% et 20%.

## Patentansprüche

1. Verfahren zur Herstellung eines Multispektralfilters, umfassend eine Vielzahl von Filterelementen, wobei jedes Filterelement angepasst ist, um ein Spektralband elektromagnetischer Strahlung aus einer Vielzahl von Spektralbändern zu übertragen, **dadurch gekennzeichnet**, das das Verfahren die folgenden Schritte umfasst:
- Ablagern eines ersten gemeinsamen Reflektors (1 - 6; 1 - 11) für die Vielzahl von Filterelementen auf einem Substrat,
- Ablagern, auf dem ersten Reflektor, eines ersten Hohlraumstapels (7 - 15; 12 - 16), umfassend mindestens N Hohlraumschichten und N-1 Sperrschichten, die abwechselnd abgelagert sind, wobei die obere Schicht eine Hohlraumschicht ist,
- selektives Gravieren einer Anzahl M von Hohlraumschichten in einer Vielzahl von Zonen, die jeweils einem Filterelement entsprechen, wobei M von 0 bis N-1 von einer Zone zur anderen variiert, und
- selektives Gravieren der Sperrschichten, die sich zwischen den gravierten Hohlraumschichten befinden,
so dass jedes Filterelement N-M Hohlraumschichten und N-M-1 nicht gravierte Sperrschichten umfasst, die einen Hohlraum bilden,
wobei die Hohlraumschichten und die Sperrschichten aus verschiedenen und optisch transparenten Materialien hergestellt sind,
wobei die Schritte des selektiven Gravierens der Hohlraumschichten und der Sperrschichten wie folgt ausgeführt werden:
- entweder durch alternierendes Gravieren der Hohlraumschichten und der Sperrschichten eine nach der anderen mit einem Gravurmuster, das an das Material der Hohlraumschichten angepasst ist, und einem Gravurmuster, das an das Material der Sperrschichten angepasst ist,
- oder durch das Gravieren der Hohlraumschichten und der Sperrschichten mit einem Gravurmuster, das an das Material der Hohlraumschichten angepasst ist, mit Ausnahme der letzten Sperrschicht, die mit einem Gravurmuster graviert ist, das an das Material der Sperrschichten angepasst ist.

2. Verfahren nach Anspruch 1, umfassend außerdem
- Ablagern eines zweiten gemeinsamen Reflektors (16 - 20; 17 - 39) auf den Hohlräumen für die Vielzahl von Filterelementen nach den selektiven Gravuren.

3. Verfahren nach Anspruch 2, umfassend außerdem
- das Ablagern, auf dem zweiten Reflektor (17 - 39), eines zusätzlichen Hohlraumstapels (40 - 44), der identisch mit dem ersten Hohlraumstapel ist, und
- das Wiederholen der Schritte des selektiven Gravierens für den zusätzliche Stapel,
so dass jedes Filterelement die gleiche Anzahl von Hohlraumschichten im ersten Stapel und dem zusätzlichen Stapel und die gleiche Anzahl von Sperrschichten in den zwei Stapeln umfasst.

4. Verfahren nach Anspruch 3, umfassend außerdem:
- das Ablagern eines dritten gemeinsamen Reflektors (45 - 55) für die Vielzahl von Filterelementen.

5. Verfahren nach einem der Ansprüche 1 bis 4, wobei die Reflektoren mindestens eines von einem Stapel von dielektrischen Schichten, einem metallischen Spiegel und einem Stapel von photonischen Kristallen umfassen.

6. Verfahren nach einem der vorhergehenden Ansprüche, wobei die Schichten des Stapels in einem einzigen Ablagerungsvorgang abgelagert werden.

7. Verfahren nach einem der vorhergehenden Ansprüche, umfassend außerdem das Ablagern einer Schutzschicht vor jeder selektiven Gravur der Hohlraumschichten auf den nicht gravierten Zonen der Hohlraumschichten.

8. Verfahren nach Anspruch 7, wobei die Schutzschichten durch Photolithographie abgelegt werden.

9. Verfahren nach einem der vorhergehenden Ansprüche, wobei das Substrat aus der sensiblen Oberfläche eines Infrarot-Photodetektors besteht.

10. Verfahren nach einem der vorhergehenden Ansprüche, wobei die Hohlraumschichten aus Germanium sind und die Sperrschichten aus Zinksulfid, aus Yttriumoxid (III) oder aus Yttriumfluorid (III) oder umgekehrt sind.

11. Verfahren nach einem der Ansprüche 1 bis 9, wobei die Hohlraumschichten aus Yttriumoxid (III) und die Sperrschichten aus Silizium oder umgekehrt sind.

12. Verfahren nach einem der vorhergehenden Ansprüche, wobei N gleich oder grösser als 2 ist.

13. Multispektralfilter, hergestellt gemäß dem Verfahren nach einem der Ansprüche 1 bis 12, wobei der Filter Hohlraumschichten und Sperrschichten umfasst, so dass das Verhältnis der Dicken der alternierend abgelagerten Sperrschichten und Hohlraumschichten im Allgemeinen zwischen 5 % und 20 % liegt.

## Claims

1. A method for manufacturing a multi-spectral filter comprising a plurality of filter elements, each filter element being adapted to transmit a spectral band of electromagnetic radiation among a plurality of spectral bands, **characterized in that** the method comprises the following steps:
- depositing a first common reflector (1-6; 1-11) for the plurality of filter elements on a substrate,
- depositing, on the first reflector, a first cavity stack (7-15; 12-16) comprising at least N cavity layers and N-1 barrier layers deposited alternately, the upper layer being a cavity layer,
- selectively etching a number M of cavity layers in a plurality of zones each corresponding to a filter element, where M varies from 0 to N-1 from one zone to another, and
- selectively etching the barrier layers located between the etched cavity layers,
such that each filter element comprises N-M cavity layers and N-M-1 non-etched barrier layers forming a cavity,
the cavity layers and the barrier layers being made of different and optically transparent materials,
the steps of selectively etching the cavity layers and the barrier layers being carried out:
- either by etching the cavity layers and the barrier layers alternately, one after the other, with an etching recipe adapted to the material of the cavity layers and an etching recipe adapted to the material of the barrier layers,
- or by etching the cavity layers and the barrier layers with an etching recipe adapted to the material of the cavity layers, with the exception of the last barrier layer, which is etched with an etching recipe adapted to the material of the barrier layers.

2. The method according to claim 1, further comprising:
- depositing a second common reflector (16-20; 17-39) on the cavities for the plurality of filter elements following the selective etchings.

3. The method according to claim 2, further comprising:
- depositing, on the second reflector (17-39), an additional cavity stack (40-44) identical to the first cavity stack, and
- repeating the selective etching steps for the additional stack,
such that each filter element comprises the same number of cavity layers in the first stack and the additional stack and the same number of barrier layers in both stacks.

4. The method according to claim 3, further comprising:
- depositing a third common reflector (45-55) for the plurality of filter elements.

5. The method according to one of claims 1 to 4, wherein the reflectors comprise at least one of a stack of dielectric layers, a metal mirror, and a stack of photonic crystals.

6. The method according to one of the preceding claims, wherein the layers of the stack are deposited in a single deposition operation.

7. The method according to one of the preceding claims, further comprising depositing a protective layer prior to each selective etching of the cavity layers on the non-etched areas of the cavity layers.

8. The method of claim 7, wherein the protective layers are deposited by photolithography.

9. The method according to one of the preceding claims, wherein the substrate consists of the sensitive surface of an infrared photo-detector.

10. The method according to one of the preceding claims, wherein the cavity layers are made of Germanium and the barrier layers are made of zinc sulfide, yttrium (III) oxide or yttrium (III) fluoride or vice versa.

11. The method according to one of claims 1 to 9, wherein the cavity layers are made of yttrium (III) oxide and the barrier layers are made of silica or vice versa.

12. The method according to one of the preceding claims, wherein N is greater than or equal to 2.

13. A multi-spectral filter manufactured according to the method of one of claims 1 to 12, the filter including cavity layers and barrier layers, such that the ratio of the thicknesses of the barrier layers and cavity layers arranged alternating is generally between 5% and 20%.
